# EUROPEAN PATENT APPLICATION

(11) **EP 1 780 548 A1**
(43) Date of publication of application: **02.05.2007**
(21) Application number: 05767082.0
(22) Date of filing: 28.07.2005
(51) Int. Cl.: G01N 37/00, G01N 35/08, B81B 1/00

(54) **MICROCHEMICAL CHIP**

(30) Priority: 29.07.2004 JP 2004221188; 27.09.2004 JP 2004278630; 27.01.2005 JP 2005020250
(71) Applicant: Kyocera Corporation, Kyoto-shi, Kyoto-fu 612-8501 (JP)
(72) Inventor: YOKOMINE, Kuninori, Kyocera Corporation, Kokubu-shi, Kagoshima 8994396 (JP)
(74) Representative: Siegert, Georg
(86) International application number: PCT/JP2005/013848
(87) International publication number: WO 2006/011558

(57) **Abstract**

A microchemical chip of the present invention has a base composed of a ceramic and a light-transmitting member. The base composed of a ceramic is provided with a channel, a fluid supplying section disposed on the upstream side of the channel, a fluid reacting section disposed on the downstream side of the fluid supplying section, and a detecting section disposed on the downstream side of the fluid reacting section. The light-transmitting member is disposed so as to cover the detecting section of the base. With this configuration, the channel is formed in the base composed of a ceramic excellent in chemical resistance and heat resistance, thereby enabling reliability to be improved. Since the light-transmitting member is disposed so as to cover the detecting section, the reaction product can be inspected by an optical technique, for example, thereby enabling detection accuracy to be improved.

## Description

### TECHNICAL FIELD

The present invention relates to a microchemical chip capable of carrying out the chemical reaction of a fluid such as a stroma and a reagent, and detecting the result of the reaction thereof. In particular, the present invention relates to a microchemical chip equipped with a minute channel.

### BACKGROUND ART

In the fields of chemical technology and biotechnology, researches for carrying out the reactions against reagents and the analyses of samples in a minute region have been made in the recent years. There are researched and developed microchemical systems for miniaturizing the systems used in chemical reactions and biochemical reactions, and in the analyses of samples, and the like, by using MEMS (micro electro mechanical systems).

The reactions and the analyses in the microchemical system can be carried out by using a chip called microchemical chip provided with a micro channel, a micro-pump, a micro-reactor, and the like. For example, there has been proposed a microchemical chip (patent literature 1 and patent literature 2). That is, a supply port for supplying a fluid such as a sample and a reagent, and a discharging port for discharging the fluid after processing are formed in a base composed of silicon, glass, or resin. The supply port and the discharging port are connected by a micro-channel having a small sectional area, and a micro-pump for feeding a fluid is disposed at an appropriate position in the micro-channel.

As means for feeding a fluid, there has been proposed a capillary migration type one using electroosmosis phenomenon, instead of the micro-pump (patent literature 3). In this microchemical chip, the micro-channel confluents or branches at a predetermined position; so that the fluid can be mixed at a confluence part and separated at a branch part.

Specifically, the microchemical chips are applicable to the measurements of a blood sugar value in blood, the hybridization of a double strand of an inspection DNA and a known DNA, and the detection of environmental toxic substances such as dioxins, PCBs, and the like.

Since the microchemical chips have miniaturized equipment and configuration as compared with the conventional systems, the reaction surface area per unit volume of a sample can be increased to thereby considerably reduce the reaction time. Further, the microchemical chips enable accurate control of a flow rate, thus permitting efficient reaction and analysis. It is also capable of reducing the amounts of the sample and the reagent necessary for the reaction and the analysis.

However, in the above-mentioned conventional microchemical chips, etching process using MEMS technique is required to form the channel because the base is composed of silicon, glass, or resin. For example, with the technique as described in patent literature 4, a microchip having a projected part within a channel can be manufactured by repetitively performing etching with respect to a silicon base. There may arise the problems of poor productivity and expensive manufacturing costs.

In the microchemical chips using the base composed of silicon, glass, or resin, vapor deposition or other method is used to form a heater, electrodes, electric circuits, and the like. In this manner, however, the strength of connection with a metal material is lowered, resulting in poor reliability. Patent literature 1: Japanese Unexamined Patent Publications Nos. 2002-214241
Patent literature 2: Japanese Unexamined Patent Publications Nos. 2002-233792
Patent literature 3: Japanese Unexamined Patent Publication No. 2001-108619
Patent literature 4: Japanese Unexamined Patent Publication No. 2002-233792

### DISCLOSURE OF THE INVENTION

The present invention has for its object to provide a microchemical chip capable of improving reliability and inspection accuracy.

According to an embodiment of the present invention, a microchemical chip has a base composed of a ceramic, and a light-transmitting member. The base composed of a ceramic is provided with a channel, and has a fluid supplying section disposed on the upstream side of the channel, a fluid reacting section disposed on the downstream side of the fluid supplying section, and a detecting section disposed on the downstream side of the fluid reacting section. The light-transmitting member is disposed so as to cover the detecting section of the base.

According to another embodiment of the present invention, a microchemical chip is composed of a ceramic and provided with a base having a plurality of supply channels, a fluid reacting section connected to the plurality of supply channels, and a detecting section connected to the fluid reacting section, and a light-transmitting member disposed so as to cover the detecting section of the base.

The respective microchemical chips of the present invention thus configured are capable of improving reliability and inspection accuracy. That is, in the microchemical chips of the present invention, an improvement of reliability is achievable by the channel formed in the base composed of a ceramic having superior chemical resistance and heat resistance. The light-transmitting member covering the detecting section enables the reaction product to be inspected by, for example, an optical technique, thereby improving inspection accuracy.

### BRIEF DESCRIPTION OF THE DRAWINGS

Fig. 1(a) is a plan view showing an example of a preferred embodiment of a microchemical chip of the present invention; and Fig-. 1(b) is a sectional view taken along the line I-I in the microchemical chip of Fig. 1(a);
Fig. 2(a) is a plan view showing another example of the preferred embodiment of the present invention; and Fig. 2(b) show sectional views taken along the line II-II, the line III-III, and the line IV-IV in the microchemical chip of Fig. 2(a), respectively;
Figs. 3(a) to 3(c) are plan views showing the processed states of respective green sheets to be stacked; and
Fig. 4 is a sectional view showing the state in which the green sheets in Figs. 3 are stacked one upon another.

### PREFERRED MODE FOR CARRYING OUT THE INVENTION

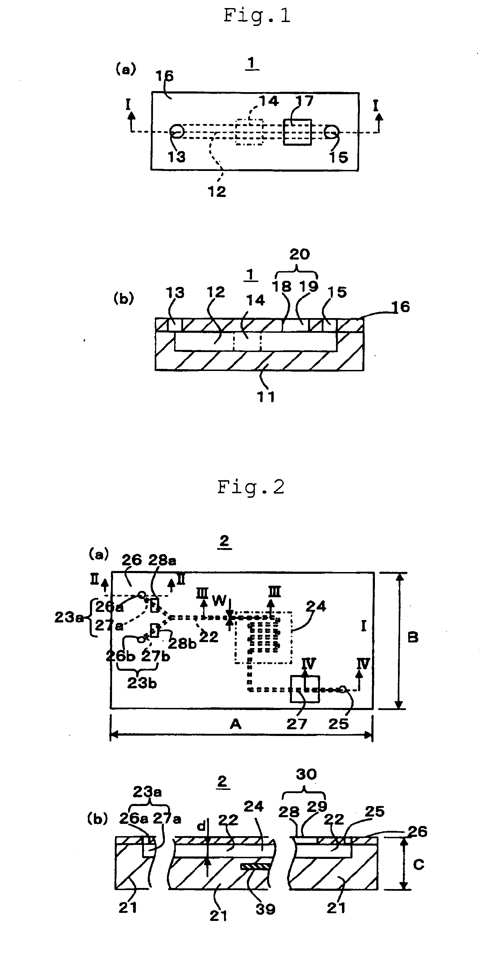

Preferred embodiments of the present invention will be described below with reference to the accompanying drawings.
Referring to Figs. 1(a) and 1(b), a microchemical chip 1 of the present invention has a base 11 composed of a ceramic which is provided with a channel 12 and a light-transmitting member 19. The channel 12 of the base 11 is provided with a fluid supplying section 13 of a fluid, a fluid reacting section 14, a detecting section 17, and a discharging part 15. The light-transmitting member 19 is disposed so as to cover the detecting section 17 of the base 11.

In the microchemical chip 1 shown in Figs. 1(a) and 1(b), the channel 12 is formed in the surface of the base 11 composed of a ceramic, and a covering member 16 composed of a ceramic is disposed on the surface of the base 11 so as to cover the channel 12. An opening part 18 is formed at a region corresponding to the detecting section 17 of the base 11 in the covering member 16, and the light-transmitting member 19 is provided at the opening part 18. Opening parts are disposed at regions of the covering member 16, which correspond to the supplying part 13 and the discharging part 15 in the base 11, respectively. Heating means such as a heater is disposed below the channel 12 in the fluid reacting section 14.

The base 11 and the covering member 16 are composed of, for example, aluminium oxide sintered body (alumina ceramic mullite sintered body, or glass ceramic sintered body. In consideration of heat resistance and chemical resistance, alumina sintered body is preferred.
The light-transmitting member 19 is composed of light-transmitting resin such as silicone resin, glass, acryl, quarts, sapphire, or plastic. Among others, light-transmitting resin is preferred.

In the microchemical chip 1 of the present invention, a fluid can be introduced from the supplying part 13, and a treatment such as chemical reaction is carried out at the fluid reacting section (processing part) 14. The fluid after subjected to the chemical reaction or the like is then inspected at the fluid reacting section 17 by an optical technique or the like, and discharged from the discharging part 15 to the outside of the microchemical chip 1.

For example, with a reagent secured to the fluid reacting section 14, a fluid containing a stroma (a biomaterial such as gene, cell, or the like) is introduced from the fluid supplying section 13, and the stroma is then allowed to react with the reagent at the fluid reacting section 14. In the detecting section 17, the reaction product after the reaction is inspected by an optical technique or the like, and the reaction product after passing though the detecting section 17 is then taken out through the discharging part 15.

The microchemical chip 1 is capable of improving reliability and inspection accuracy by the presences of the base 11 composed of a ceramic, and the light-transmitting member 19 disposed so as to cover the detecting section 17 of the base 11. That is, the microchemical chip 1 is capable of improving reliability by the channel 12 formed in the base 11 composed of a ceramic having superior chemical resistance and heat resistance. Additionally, the light-transmitting member 19 disposed so as to cover the detecting section 17 enables the reaction product to be inspected by, for example, an optical technique, thereby improving inspection accuracy.

Further, the microchemical chip 1 requires no complicated process such as etching process because the base 11 is composed of a ceramic, thus enabling to form the channel 12 of high reliability.

### <First Preferred Embodiment>

Unlike the microchemical chip 1 shown in Figs. 1, in a microchemical chip according to a first preferred embodiment of the present invention, the light-transmitting member 19 can be configured by stacking on a light-transmitting resin a different light-transmitting member having a higher hardness than the light-transmitting resin.

As an example of this configuration, there is one in which glass, acryl, quarts, sapphire, plastic, or the like is laminated on a silicone resin. In consideration of productivity and the strength of the light-transmitting member 19, such a configuration that glass is laminated on a silicone resin is especially preferred.

In order to improve the sealing property of the detecting section 17 by the light-transmitting member 19 covering the detecting section 17, the hardness of the light-transmitting resin is preferably 4 to 11 in the measurement immediately after a pressing surface is closely contacted in a hardness test (Japanese Rubber Association Standard SRIS 0101, Spring ASKERC type) with a hardness tester (manufactured by Erasutoron Co., Ltd., Product name of "Rubber Hardness Tester Model ESC"), and its tackiness is preferably 3 to 5 in the measurement on a slope of 30 degrees with a ball rolling method in a ball tack test (JIS Z 0237) by using a tackiness tester (manufactured by Bansei Co., Ltd., Product name of "Adhesive Tack Tester, Model No. LST-57").

When the hardness of the light-transmitting resin is above 11, it is difficult to allow the light-transmitting member 19 to adhere to the base 11 having irregularities on the surface thereof, thereby increasing the likelihood of the leakage of the fluid. When the hardness is below 4, the light-transmitting member 19 may deflect and hang over the channel 12 and the detecting section 17.

When the tackiness of the light-transmitting resin is above 5, the fine particles in the fluid after the reaction may adhere to the surface of the light-transmitting member 19, and the accuracy of detecting the reaction product may be lowered. When the tackiness is below 3, the connecting property between the base 11 and the light-transmitting member 19 may be lowered, and spacing may occur in the interface therebetween, thus lowering sealing property.

In order to proceed the reaction with an accurate flow rate while maintaining the sectional area of the channel 12, it is preferable that a different light-transmitting member to be stacked on the light-transmitting resin has a hardness of 12 or more in the measurement immediately after a pressing surface is closely contacted in the hardness test (Japanese Rubber Association Standard SRIS 0101, Spring ASKERC type) with the hardness tester (manufactured by Erasutoron Co., Ltd., Product name of "Rubber Hardness Tester Model ESC").

When the hardness of the different light-transmitting member stacked on the light-transmitting resin is below 12, the fluid passing through the channel 12 may increase the pressure within the channel 12 to thereby deform the light-transmitting member 19.
There is no possibility that the glass of the first class in Knoop hardness, namely the lowest hardness, may have a hardness lower than the hardness of the light-transmitting resin having a hardness of 12 in the measurement immediately after a pressing surface is closely contacted in the hardness test (Japanese Rubber Association Standard SRIS 0101, Spring ASKERC type) with the hardness tester (manufactured by Erasutoron Co., Ltd., Product name of "Rubber Hardness Tester Model ESC").

The arithmetic average surface roughness (JIS B 0601-1994) of the surface of the base 11 is preferably 5 µm or below, more preferably in a range of 0.05 to 5 µm. When it is above 5 µm, it is difficult to allow the light-transmitting member 19 covering the detecting section 17 to adhere to the base 11 having irregularities on the surface thereof, thus increasing the likelihood of the leakage of the fluid. When it is bellow 0.05 µm, sealing property can be further improved. However, in general, in order that the surface of a ceramic has a mirror surface, the post-process such as polishing process is required after sintering, and due to this process, the channel 12 and the detecting section 17 may be deformed or contaminated.
When requiring any heating means such as a heater, the covering member 16 may be formed of the light-transmitting member 19.

In the microchemical chip 1, when introducing a fluid from the fluid supplying section 13, the fluid can be fed from the fluid supplying section 13 to the discharging part 15 by introducing the fluid with a micro-syringe or the like. In an alternative, the fluid can be fed from the fluid supplying section 13 to the discharging part 15 by introducing the fluid while applying pressure thereto with a pump or the like provided externally. In another alternative, the fluid can be fed by sucking the fluid from the discharging part 15 with a micro-syringe or the like, when the fluid is introduced from the fluid supplying section 13.

In the microchemical chip of the first preferred embodiment thus configured, the fluid passing through the channel 12 may increase the pressure within the channel 12 to thereby reduce the deformation of the light-transmitting member 19. Thus, the reaction can be carried out with the accurate flow rate while maintaining a specific sectional area of the channel 12.

That is, the microchemical chip having excellent chemical resistance and heat resistance, and the improved detection accuracy can be provided by the characteristic feature that the base 11 is composed of a ceramic, and the light-transmitting member 19 covering the detecting section 17 of the base 11 is formed by stacking on the light-transmitting resin the different light-transmitting member having a higher hardness than the light-transmitting resin.

### <Second Preferred Embodiment>

Referring to Figs. 2, a microchemical chip 2 according to a second preferred embodiment of the present invention has a base 21 composed of a ceramic, and a covering member 26 composed of a ceramic. The base 21 is provided with a channel 22, a plurality of fluid supplying sections 23a and 23b, a fluid reacting section (a processing part) 24, a detecting section 27, and a discharging part 25. The fluid supplying section 23a contains a supply channel 27a, a supply port 26a disposed at an end part of the supply channel 27a, and a micro-pump 28a disposed above the supply channel 27a. Similarly, the fluid supplying section 23b contains a supply channel 27b, a supply port 26b disposed at an end part of the supply channel 27b, and a micro-pump 28b disposed above the supply channel 27b. The supply ports 26a and 26b are opened so that a processed fluid can be introduced from the outside to the supply channels 27a and 27b, respectively. In the detecting section 27, a light-transmitting member 29 is fit in an opening part 28 so that an inspection can be performed by an optical technique such as visual observation, microscopic examination, or spectral analysis. The discharging part 25 is opened so that the processed fluid can be discharged from the channel 22 to the outside.

A heater 39 is disposed below the channel 22 of the fluid reacting section 24 in the inside of the base 21. The channel 22 of the fluid reacting section 24 is formed by holding back so as to pass through above the heater 39 a plurality of times. Wiring (not shown) for connecting the heater 39 and external electrodes extends from the heater 39 on the surface of the base 21. This wiring is formed of a metal material having a lower resistance value than the heater 39.

In the microchemical chip 2, a plurality of kinds of processed fluids are introduced into the channel 22 from the plurality of fluid supplying sections 23a and 23b, respectively, and the processed fluids are then allowed to confluent. As needed, the channel 22 is heated to a predetermined temperature at the fluid reacting section 24 by using the heater 39 in order to allow the introduced processed fluids to react with each other. The obtained reaction product is detected by the detecting section 27 and then discharged through the discharging part 25 to the outside.

For example, a compound can be synthesized by introducing a processed fluid containing a compound as a raw material from the fluid supplying section 23a, introducing a processed fluid containing a reagent from the fluid supplying section 23b, and heating the channel 22 of the fluid reacting section 24 by the heater 39. In the detecting section 27, the obtained compound (the reaction product) is inspected on a microscope through the light-transmitting member 29 fit in the opening part 28, and thereafter the reaction product is discharged through the discharging part 25.

In order to efficiently feed and mix a specimen, a reagent, or a cleaning solvent to be introduced from the fluid supplying sections 23a and 23b, the sectional areas of the channel 22 and the supply channels 27a and 27b are preferably not less than 2.5 × 10⁻³mm² nor more than 1 mm². When the above-mentioned sectional areas are above 1 mm², the amount of feed of the specimen, the reagent, or the cleaning solvent becomes excessive. There may arise the possibility of failing to sufficiently obtain the effects of the microchemical chip, namely an increase in the reaction surface area per unit volume, and a considerable reduction in the reaction time. When it is below 2.5 × 10⁻³mm², the loss of pressure due to the micro-pumps 28a and 28b may be increased.

From the viewpoint of the efficient feed of fluids and miniaturization, the width w of each of the channel 22 and the supply channels 27a and 27b is preferably 50 to 1000 µm, more preferably 100 to 500 µm. The depth d of each of the channel 22 and the supply channels 27a and 27b is preferably 50 to 1000 µm, more preferably 100 to 500 µm. The relationship between the width and the depth is preferably expressed by: shorter side length (depth)/longer side length (width) ≧0.4, more preferably, shorter side length/longer side length ≧0.6. When shorter side length/longer side length <0.4, the loss of pressure is increased to cause a problem in feeding the fluid.

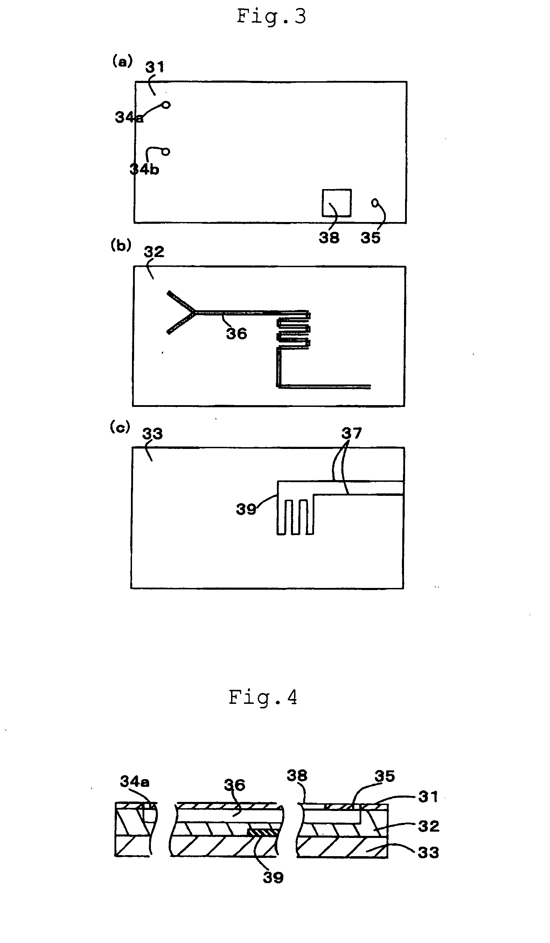

A method of manufacturing the microchemical chip 2 shown in Figs. 2 will next be described. Figs. 3 are plan views showing the processed states of ceramic green sheets 31, 32, and 33, respectively. Fig. 4 is a sectional view showing the state in which the ceramic green sheets 31, 32, and 33 are stacked one upon another.

First, a raw material powder is mixed with a suitable organic binder and a solvent, and as needed, plasticizer or dispersing agent is added thereto to obtain slurry. This slurry is then formed in the shape of a sheet by doctor blade method, calendar roll method, or the like, thereby forming a ceramic green sheet (a ceramic raw sheet, hereinafter referred to as a "green sheet" in some cases). For example, when the base 21 is composed of aluminium oxide sintered body, examples of the raw material powder are alminium oxide, silicon oxide, magnesium oxide, calcium oxide, and the like. The present embodiment uses three green sheets thus formed.

Referring to Fig. 3(a), through-holes 34a and 34b serving as the supply ports 26a and 26b, respectively, a through-hole 38 serving as the detecting section 27, and a through-hole 35 serving as the discharging part 25 are formed in the green sheet 31.
Referring to Fig. 3(b), a groove 36 is formed in the green sheet 32 by pressing with a die, for example. The pressure to be applied when pressing with the die can be adjusted according to the viscosity of the slurry before being formed into the green sheet. For example, when the viscosity of the slurry is 1 to 4 Pa·s, the pressure of 2.5 to 7 MPa is applied. No particular limitation is imposed on the material of the die, and it may be metal or wood.

Referring to Fig. 3(c), the heater 39 and a wiring pattern 37 for connecting an external power source are formed on the surface of the green sheet 33 by applying a conductive paste in a predetermined shape by screen printing method or the like. The conductive paste can be obtained by mixing a metal material powder such as tungsten, molybdenum, manganese, copper, silver, nickel, palladium, or gold, with suitable resin binder and solvent. The conductive paste for forming the heater 39 can be prepared by adding 5 to 30 weight % of ceramic powder to the above-mentioned metal material powder so as to attain a predetermined resistance value after sintering.

Referring to Fig. 4, the green sheet 32 provided with the groove 36 is stacked on the surface of the green sheet 33 provided with the heater 39. Then, the green sheet 31 provided with the through-holes 34a, 34b, 35, and 38 each being formed so as to cover the groove 36 is stacked on the surface of the green sheet 32. The green sheets 31, 32, and 33 thus stacked are then sintered and integrated by sintering at about 1600°C.

Successively, micro-pumps 28a and 28b are formed by sticking a piezoelectric material such as lead zirconate titanate (PZT, composition formula: Pb (Zr, Ti)O₃) to a predetermined position on the surface provided with the through-holes 34a, 34b, 35, and 38. The piezoelectric material can vibrate the covering member 26 above the channel 22 by expanding and contracting in response to the applied voltage, thereby functioning as the micro-pumps 28a and 28b for feeding the fluid.

Then, the light-transmitting member 29 formed to the dimension of the through-hole 38 is fit in the through-hole 38. The light-transmitting member 29 is preferably composed of a light-transmitting resin such as silicone resin.
Preferably, the light-transmitting resin has a hardness of 4 to 11 in the measurement immediately after a pressing surface is closely contacted in the hardness test (Japanese Rubber Association Standard SRIS 0101, Spring ASKERC type) with the hardness tester (manufactured by Erasutoron Co., Ltd., Product name of "Rubber Hardness Tester Model ESC"), and has a tackiness of 3 to 5 in the measurement on the slope of 30 degrees with the ball rolling method in the ball tack test (JIS Z 0237) by using the tackiness tester (manufactured by Bansei Co., Ltd., Product name of "Adhesive Tack Tester Model No. LST-57").
Alternatively, the light-transmitting member 29 may be one in which glass is laminated on a light-transmitting resin.

Thus, in the method of manufacturing the microchemical chip 2 of the present embodiment, the base 21 having the channel 22 can be formed by forming the groove 36 in the surface of the green sheet 32, then laminating the green sheet 31 so as to cover the groove 36, followed by sintering of the laminated green sheets 31, 32, and 33 so as to be sintered and integrated. Since a ceramic is excellent in chemical resistance and heat resistance, the heater, the electrodes, the electric circuit, and the like can be formed and housed by simultaneous sintering, thereby facilitating the multilayer formation necessary for the three dimensional configuration of the channel 22. Additionally, when the light-transmitting member 29 covering the detecting section 27 is engaged with the opening part 28 formed at the region of the covering member 26 composed of a ceramic which is opposed to the detecting section 27 of the base 21, the results of the reaction and the like can be detected easily at the detecting section 27 in the microchemical chip 2 by an optical technique such as visual observation, microscopic examination, or spectral analysis. Hence, the microchemical chip 2 of the present invention can be used under various conditions.

Although the microchemical chip 2 of the second preferred embodiment has the two fluid supplying sections 23a and 23b, without limiting to this, it may have three or more fluid supplying sections. When disposing two or more fluid supplying sections, the supply channels of the fluid supplying sections are not required to confluent at a position, and they may be connected at different positions of the channel 22. Although the heater 39 is provided at a location, without limiting to this, it may be provided at two or more locations. Consequently, a further complicated reaction can be controlled by providing three or more fluid supplying sections and disposing the heaters at two or more locations.

Although in the method of manufacturing the microchemical chip 2 of the second preferred embodiment, the channel 22 of the base 21 is formed of the two green sheets, namely the green sheet 32 provided with the groove 36 and the green sheet 31 laminated so as to cover the groove 36, without limiting to this, it may be formed out of three or more green sheets. In this case, grooves 36 are formed in two or more green sheets, respectively, and through-holes for bringing the respective grooves 36 into communication are formed in a different green sheet. For example, when the channel 22 is formed out of three green sheets, a base is formed in the following manner. Like the green sheet 31 shown in Fig. 3(a), a through-hole communicating with a groove 36 formed in the second green sheet is formed in the first green sheet. The surfaces of the second and third green sheets are pressed with a predetermined-shaped die to form through-holes 36, respectively. Through-holes for communicating with the grooves 36 in the second and third green sheets, respectively, are formed in the second green sheet.

A different green sheet is stacked on the surface of the green sheet provided with the groove 36 so as to cover the groove 36. That is, the second green sheet is stacked on the surface of the third green sheet so as to cover the groove 36 formed in the third green sheet, and the first green sheet is stacked on the surface of the second green sheet so as to cover the groove 36 formed in the second green sheet. At this time, the respective green sheets are stacked so that the groove 36 formed in the second green sheet and the groove 36 formed in the third green sheet can communicate through the through-hole formed in the second green sheet. Like the case of forming the above-mentioned base 21, the base 21 can be obtained by sintering the green sheets thus stacked at a predetermined temperature. In the base 21 thus obtained, the channel 22 can be formed in three dimensions.

The processed fluid passing through the channel 22 in the microchemical chip 2 becomes a laminar flow. Therefore, when the channel 22 is allowed to confluent in a plane in order to mix a plurality of processed fluids, the processed fluids can be mixed only by diffusion, and hence a long distance is required to sufficiently mix them. However, by forming the channel 22 in three dimension near the downstream side of a confluence part, the plurality of processed fluids can be mixed easily.

When the channel 22 is formed out of four green sheets, grooves are formed in the second and fourth green sheets, respectively, and through-holes communicating with the grooves 36 formed in the second and fourth green sheets, respectively, are formed in the second and third green sheets. Thereafter, the third, the second, and the first green sheets are stacked in the order named on the surface of the fourth green sheet, followed by sintering.

Although the piezoelectric material functioning as the micro-pumps 28a and 28b is stuck after sintering the stacked green sheets, when using the ceramic piezoelectric material such as the above-mentioned PZT, it is also possible to perform a simultaneous sintering after fixing the ceramic piezoelectric material to a predetermined position of the green sheet 31.

### <Examples>

Examples of the microchemical chip of the present invention will be described below. Samples for evaluation of the microchemical chips used in the second preferred embodiment were manufactured in the following manner. First, doctor blade method was used to form green sheets in which slurry composed of aluminium oxide material had a viscosity of 2 Pa·s. Two of these green sheets were used. In the first green sheet serving as a covering member, a fluid supplying section and a discharging part each having a diameter of 2 mm are formed, and a through-hole communicating with a channel to be formed in the second green sheet serving as a base is formed by metal die punching at a predetermined position where a detecting section having a length of 5 mm and a width of 5 mm is provided in between the fluid supplying section and the discharging part.
Next, a die is pressed against the surface of the second green sheet under pressure of 5 MPa, thereby forming a linear channel having a width of 100 µm, a depth of 100 µm, and a length of 5 cm.

Thereafter, the first green sheet was stacked on the surface of the second green sheet, and then sintered and integrated by sintering at a temperature of about 1600°C. There was manufactured a microchemical chip composed of a ceramic having an outside dimension of 40 mm in width, 70 mm in length, and 1 mm in thickness. The surface after sintering had an arithmetic average roughness Ra of 5 µm. Separately, after sintering, the surface was physically roughened to manufacture a microchemical chip composed of a ceramic having an arithmetic average roughness Ra of 6 µm. As used herein, the arithmetic surface roughness was based on the standard of JIS B 0601-1994, setting the cut-off value to 2.5 mm, and the evaluation length to 12.5 mm.

Further, a covering member composed of silicone resin having a length of 5 mm, a width of 5 mm, and a thickness of 0.5 mm, or a covering member in which, as a laminated matter, glass or acryl having a thickness of 0.25 mm was laminated on silicone resin having a thickness of 0.25 mm, was fit in the opening part of the detecting section. The silicone resin is composed of polydimethyl siloxane, and various silicone resins were manufactured by adjusting their hardness to different values of 2, 3, 4, 5, 6, 7, 8, 9, 10, 11, 12, and 13, respectively, and adjusting their tackiness to different values of 2, 3, 4, 5, 6, and 7, respectively, in the manner of changing the degree of crosslinking depending on the amount of application of curing agent and the heat treatment condition.

The hardness of each of the silicone resins was measured immediately after a pressing surface was closely contacted in the hardness test (Japanese Rubber Association Standard SRIS 0101, Spring ASKERC type) with the hardness tester (manufactured by Erasutoron Co., Ltd., Product name of "Rubber Hardness Tester Model ESC"), and the tackiness was measured on the slope of 30 degrees with the ball rolling method in the ball tack test (JIS Z 0237) by using the tackiness tester (manufactured by Bansei Co., Ltd., Product name of "Adhesive Tack Tester Model No. LST-57").

In the respective samples for evaluation thus made as shown in Table 1, pure water containing white beads composed of acryl having a mean particle size of 5 µm was introduced from the supply port by a micro-syringe at a flow rate of 0.1 cm³/min. Then, the interface between the light-transmitting material fit in the opening part of the detecting section and the channel of a ceramic was observed on a stereomicroscope of X10 to X100, to check water leakage and the state of deformation of the covering member composed of the light-transmitting material. Table 1 shows the results of the microchemical chips each using the base composed of the ceramic, the arithmetic average roughness of which was adjusted to 5 µm by physically roughening the surface thereof after sintering.

In Table 1, the alphabet "A" in the column of sealing property indicates that there occurred neither bleeding nor leakage of the pure water from the interface between the covering member composed of the light-transmitting material fit in the opening part of the detecting section, and the channel of the base composed of a ceramic. The alphabet "B" indicates that the pure water bled from the interface between the covering member and the channel. The alphabet "C" indicates that the pure water leaked from the interface between the covering member and the channel, and the pure water did not reach the discharging part. The alphabet "A" in the column of the deformation of the covering member indicates that no deformation occurred in the covering member fit in the opening part of the detecting section. The alphabet "B" indicates that the covering member was deformed due to an increase in the pressure within the channel. The alphabet "C" indicates that the covering member was deformed and could not endure an increase in the pressure within the channel, thus causing bleeding and leakage of the pure water.

**Table 1**

| | | | | | | | | | |
|---|---|---|---|---|---|---|---|---|---|
| Hardness | 2 | 3 | 4 | 8 | 11 | 12 | 13 | 8 | 8 |
| Tackiness | 4 | 4 | 4 | 4 | 4 | 4 | 4 | 4 | 4 |
| Laminating matter | - | - | - | - | - | - | - | glass | acryl |
| Sealing property | C | C | A | A | A | B | C | A | A |
| Deformation of the covering member | C | C | B | B | B | C | C | A | A |

It was confirmed from Table 1 that there occurred neither bleeding nor leakage of the pure water from the interface between the covering member fit in the opening part of the detecting section, and no deformation of the covering member occurred in the samples for evaluation using the covering member in which glass or acryl was laminated on the silicone resin having a hardness of 4 to 11 and a tackiness of 4.

Next, in the respective samples for evaluation in which glass was used as the laminating matter, and the hardness and tackiness of silicone resin were changed to different values as shown in Table 2, pure water containing white beads composed of acryl having a mean particle size of 5 µm was introduced from the supply port by a micro-syringe at a flow rate of 0.1 cm³/min. Then, the interface between the light-transmitting material fit in the opening part of the detecting section and the channel was observed on a stereomicroscope of X10 to X100, to check water leakage. Table 2 shows the results of the microchemical chips each using the base composed of the ceramic, the arithmetic average roughness of which was adjusted to 6 µm by physically roughening the surface thereof after sintering.

In Table 2, the alphabet "B" indicates that the pure water bled from the interface between the covering member and the channel, and the alphabet "C" indicates that the pure water leaked from the interface between the covering member and the channel, and the pure water did not reach the discharging part.

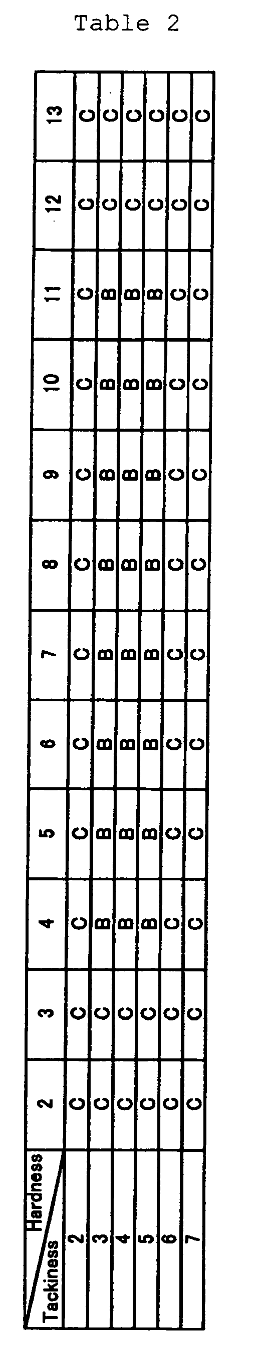

It was confirmed from Table 2 that when the surface of the base had an arithmetic average roughness of 6 µm, even if the hardness and tackiness of the silicone resin were changed, the pure water bled or leaked from the interface between the covering member fit in the opening part of the detecting section and the channel, thus causing the problem in sealing property.

Subsequently, the same water leakage test was conducted in respect to the samples for evaluation in which the surface after sintering had an arithmetic average roughness of 5 µm. Table 3 shows the results of the evaluations.
In Table 3, the alphabet "A" indicates that there occurred neither bleeding nor leakage of the pure water from the interface between the covering member fit in the opening part of the detecting section and the channel. The alphabet "B" indicates that the pure water bled from the interface between the covering member and the channel. The alphabet "C" indicates that the pure water leaked from the interface between the covering member and the channel, and the pure water did not reach the discharging part.

It was confirmed from Table 3 that neither bleeding nor leakage of the pure water from the interface between the covering member fit in the opening part of the detecting section occurred in the samples for evaluation as being the present invention, in which the surface of the base had an arithmetic average roughness of 5 µm or below, and which uses the covering member in which glass having a higher hardness than silicone resin was laminated on the silicone resin having a hardness of 4 to 11 and a tackiness of 3 to 5.

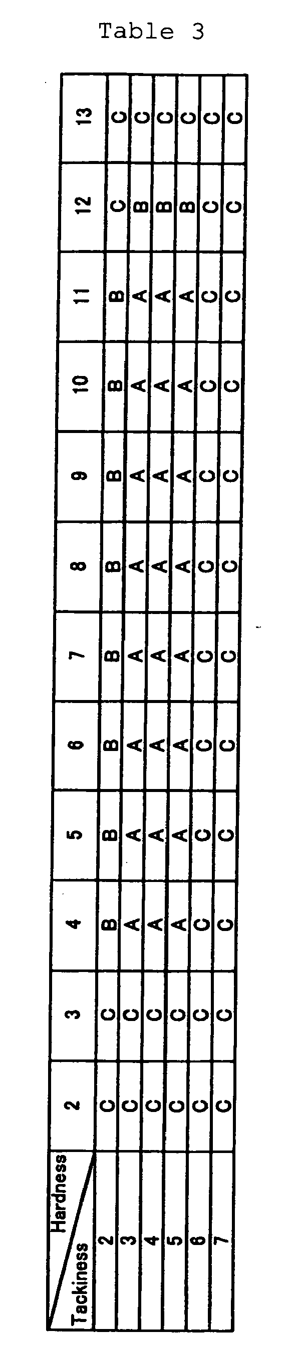

## Claims

1. A microchemical chip comprising:
a base composed of a ceramic, the base being provided with a channel which has a fluid supplying section disposed on the upstream side of the channel, a fluid reacting section disposed on the downstream side of the fluid supplying section, and a detecting section disposed on the downstream side of the fluid reacting section; and
a light-transmitting member disposed so as to cover the detecting section of the base.

2. The microchemical chip according to claim 1, wherein a covering member composed of a ceramic is disposed on a surface of the base, and
the light-transmitting member is disposed at a region corresponding to the detecting section of the base in the covering member.

3. The microchemical chip according to claim 2, wherein the base and the covering member are integrated by sintering.

4. The microchemical chip according to claim 1, wherein the light-transmitting member is composed of a light-transmitting resin.

5. The microchemical chip according to claim 1, wherein the light-transmitting member is comprised of a light-transmitting resin and a different light-transmitting member stacked on the light-transmitting resin, the different light-transmitting member having a higher hardness than the light-transmitting resin.

6. The microchemical chip according to claim 5, wherein the different light-transmitting member is glass.

7. The microchemical chip according to claim 5, wherein the light-transmitting member has a hardness of 4 to 11, and a tackiness of 3 to 5.

8. A microchemical chip comprising:
a base composed of a ceramic, the base having a plurality of supply channels, a fluid reacting section connected to the plurality of supply channels, and a detecting section connected to the fluid reacting section; and
a light-transmitting member disposed so as to cover the detecting section of the base.

9. The microchemical chip according to claim 8, further comprising:
a ceramic layer provided with a passage containing the plurality of supply channels, the fluid reacting section, and the detecting section; and
a different ceramic layer disposed on the ceramic layer and provided with an opening part at a region corresponding to the detecting section, the light-transmitting member being provided in the opening part.

10. The microchemical chip according to claim 9, wherein the light-transmitting member is fit in the opening part of the different ceramic layer.

11. The microchemical chip according to claim 8, wherein a covering member composed of a ceramic is disposed on a surface of the base, and
the light-transmitting member is disposed at a region corresponding to the detecting section of the base in the covering member.

12. The microchemical chip according to claim 11, wherein the base and the covering member are integrated by sintering.

13. The microchemical chip according to claim 8, wherein the light-transmitting member is composed of a light-transmitting resin.

14. The microchemical chip according to claim 13, wherein the light-transmitting resin is silicone resin.
